# DEMANDE DE BREVET EUROPEEN

(11) **EP 2 881 990 A1**
(43) Date de publication de la demande: **10.06.2015**
(21) Numéro de dépôt: 14195747.2
(22) Date de dépôt: 02.12.2014
(51) Int. Cl.: H01L 27/146

(54) **Procédé de réalisation d'un dispositif imageur intégré à illumination face avant comportant au moins un filtre optique métallique, et dispositif correspondant**

(30) Priorité: 04.12.2013 FR 1362088
(71) Demandeur: STmicroelectronics SA, 92120 Montrouge (FR); STMicroelectronics (Crolles 2) SAS, 38920 Crolles (FR); COMMISSARIAT A L'ENERGIE ATOMIQUE ET AUX ENERGIES ALTERNATIVES, 75015 Paris (FR)
(72) Inventeur: Girard Desprolet, Romain, 38000 GRENOBLE (FR); Lhostis, Sandrine, 38570 THEYS (FR); Boutami, Salim, 38100 GRENOBLE (FR); Marty, Michel, 38760 Saint Paul de Varces (FR)
(74) Mandataire: Casalonga

(57) **Abrégé**

Procédé de réalisation d'un dispositif imageur intégré à illumination face avant, le procédé comprenant :
- une formation d'au moins une première région diélectrique inférieure, la première région diélectrique inférieure ayant une face supérieure,
- une formation d'au moins un premier filtre optique métallique (FIL1) comportant un motif métallique, ledit filtre étant sur ladite face supérieure ou s'étendant dans la première région diélectrique inférieure depuis ladite face supérieure,
- une formation d'une première région diélectrique supérieure au-dessus de la première région diélectrique inférieure et du premier filtre optique métallique pour former avec au moins une partie de la première région inférieure une première zone diélectrique (ZD1) associée à un niveau de métallisation du dispositif imageur intégré.

## Description

Des modes de réalisation de l'invention concernent les dispositifs imageurs intégrés à illumination face avant, et en particulier les dispositifs imageurs intégrés comprenant des filtres optiques métalliques destinés à filtrer, c'est-à-dire laisser passer, différents rayonnements lumineux dans une gamme de longueur d'onde désirée, en particulier dans le domaine visible, UV ou infrarouge.

Les dispositifs imageurs à illumination face avant comprennent généralement un ensemble de pixels ayant chacun une zone photosensible semi-conductrice disposée sous un filtre optique intégré. On pourra notamment utiliser des groupes de pixels avec des filtres rouges, verts et bleus, de manière à former des motifs de Bayer bien connus de l'homme du métier.

Les filtres optiques destinés à ne laisser passer qu'une seule couleur comprennent généralement un filtre organique coloré par des pigments laissant passer l'infrarouge. Il convient généralement de leur adjoindre un filtre infrarouge supplémentaire pour des applications d'imagerie dans le domaine visible.

Les filtres colorés ont aussi pour inconvénient de ne pas être suffisamment robustes, et de ne pas pouvoir être utilisés pour les longueurs d'ondes de l'infrarouge.

Par ailleurs, un imageur multicolore nécessitera un nombre d'étapes de photolithographie proportionnel au nombre de types de filtres colorés à réaliser. Ces filtres ont également pour inconvénient d'être dégradés lorsqu'ils sont exposés à des températures qui dépassent 200°C.

D'autre part, les filtres interférentiels (dits multicouches) permettent également de réaliser des capteurs d'images sans se limiter aux longueurs d'onde du visible et ils peuvent donc être utilisés pour des applications hors du domaine visible (UV ou infrarouge). Leur structure multicouches les rend cependant chers et plus difficiles à intégrer du fait du nombre important d'étapes de dépôt nécessaires à leur réalisation et de l'épaisseur totale de l'empilement, pouvant dépasser le micron.

Il a donc été proposé des alternatives aux filtres colorés par des pigments et aux filtres multicouches.

On connaît de l'état de la technique antérieure des filtres optiques comprenant une ou plusieurs couches métalliques dans lesquelles des motifs (trous ou plots) sont formés ayant des dimensions de l'ordre de la dizaine ou de la centaine de nanomètres. Ce type de structure est mieux connu sous le nom de filtre plasmonique.

On pourra à cet effet se référer au document « Light in tiny holes » (C. Genet et T. W. Ebbesen, Nature 445, pages 39-46, 4 January 2007) qui décrit la transmission de lumière par des trous nanométriques.

On pourra également se référer au document « Structural Colors: From Plasmonic to Carbon Nanostructures » (Ting Xu et al, Small Volume 7, Issue 22, pages 3128-3136, November 18, 2011) qui décrit des filtres comprenant des motifs métalliques nanométriques pour filtrer différentes couleurs, notamment avec des motifs périodiques.

Enfin, on pourra se référer au document US 2003/0103150 qui divulgue des filtres métalliques du type présenté ci-avant qui sont formés par les mêmes étapes de fabrication que les lignes des niveaux de métallisation des circuits intégrés qui comprennent ces filtres. Les filtres décrits dans ce document ont donc la même épaisseur que les niveaux de métallisation, et ils comprennent le même matériau métallique que les lignes des niveaux de métallisation.

Les filtres métalliques obtenus dans ce dernier document peuvent ne pas être adaptés pour filtrer la lumière de manière satisfaisante. En effet, les lignes métalliques de niveaux de métallisation ont une hauteur donnée qui peut être de l'ordre de plusieurs centaines de nanomètres ou de l'ordre du micromètre, et la formation de motifs est limitée par les contraintes de photolithographie et de remplissage par du métal (notamment lors de procédés dits « Damascène »). Ainsi, la solution du document US 2003/0103150 ne permet pas de choisir précisément les dimensions des motifs qui formeront des filtres.

Généralement, on forme les éléments métalliques de niveaux de métallisation entre des couches de nitrure de silicium (SIN) ou de carbure-nitrure de silicium (SICN). Ces couches de nitrure de silicium ou de carbure-nitrure de silicium se retrouvent donc, dans la solution exposée dans le document US 2003/0103150 de part et d'autre des filtres métalliques, ce qui nuit aux propriétés optiques des filtres métalliques.

Selon un mode de mise en oeuvre et de réalisation, il est proposé de former des filtres optiques métalliques plus facilement configurables, notamment en ce qui concerne les dimensions, en fonction de l'application souhaitée, et qui présentent de meilleures propriétés optiques.

Selon un aspect, il est proposé un procédé de réalisation d'un dispositif imageur intégré à illumination face avant comprenant au moins une première zone photosensible dans un substrat, le procédé comprenant :
- une formation d'au moins une première région diélectrique inférieure au-dessus de la face avant du substrat et de la première zone photosensible, la première région diélectrique inférieure ayant une face supérieure,
- une formation d'au moins un premier filtre optique métallique comportant un motif métallique au-dessus de la première zone photosensible de pixel, ledit filtre étant sur ladite face supérieure ou s'étendant dans la première région diélectrique inférieure depuis ladite face supérieure,
- une formation d'une première région diélectrique supérieure au-dessus de la première région diélectrique inférieure et du premier filtre optique métallique pour former avec au moins une partie de la première région inférieure une première zone diélectrique associée à un niveau de métallisation du dispositif imageur intégré, ladite face supérieure de la première région diélectrique inférieure étant contenue dans ladite première zone diélectrique.

Il est possible de former le premier filtre métallique à tout niveau choisi par l'homme du métier en fonction de l'application. Par niveau, on entend ici un plan horizontal au dessus de la face avant d'un substrat. A titre indicatif, la première région diélectrique inférieure peut comprendre une portion d'une région diélectrique pré-métal (« PMD : Pre-Metal Dielectric » en langue anglaise), la première zone diélectrique correspondant alors à une région de diélectrique pré-métal, le premier filtre métallique étant noyé dans la région de diélectrique pré-métal. Cette configuration permet de placer le filtre optique métallique au plus près du substrat, ce qui a pour avantage de réduire les problèmes liés au phénomène bien connu de l'homme du métier sous l'expression anglo-saxonne « cross talk ».

Alternativement, il est possible de former un premier filtre optique métallique à un niveau plus haut, par exemple dans une région de diélectrique intermétallique (« IMD : Inter Metal Dielectric » en langue anglaise). La première région diélectrique inférieure comprend alors la région de diélectrique pré-métal, et soit une portion d'une région de diélectrique intermétallique, soit une ou plusieurs régions de diélectrique intermétallique et une portion d'une région de diélectrique intermétallique, et la première zone diélectrique associée à un niveau de métallisation comprend cette portion de région de diélectrique intermétallique et une autre portion de diélectrique intermétallique (la première région diélectrique supérieure).

On peut noter que la face supérieure de la première région diélectrique inférieure est toujours contenue dans un plan distinct de celui à partir duquel on forme un niveau de métallisation associé à la première zone diélectrique. On peut également noter qu'il est possible de former un filtre optique métallique en formant des cavités dans la première région diélectrique inférieure et en remplissant ces cavités de métal, ou en formant une couche de métal sur la première région diélectrique inférieure et en mettant en oeuvre une étape de photolithographie.

Il est donc possible de former des filtres optiques métalliques ayant des hauteurs très différentes de celles des niveaux de métallisation, ce qui permet notamment de former des motifs métalliques avec des dimensions latérales minimales différentes des dimensions latérales minimales liées aux étapes de fabrication des niveaux de métallisation.

On peut ainsi adapter plus facilement les dimensions des filtres optiques métalliques à l'application souhaitée.

On notera qu'il n'est pas nécessaire de former des couches de nitrure de silicium ou de carbure-nitrure de silicium de part et d'autre des filtres optiques métalliques, et on obtient donc une amélioration des propriétés optiques des filtres.

Le procédé peut comprendre en outre une formation d'un deuxième filtre optique métallique au-dessus d'une deuxième zone photosensible distincte de la première zone photosensible.

On peut former le premier filtre optique métallique avec un premier métal, on peut former le deuxième filtre optique métallique avec un deuxième métal différent du premier métal, la face supérieure de la première région diélectrique inférieure associée au premier filtre optique métallique étant contenue dans un plan distinct du plan contenant la face supérieure d'une deuxième région diélectrique inférieure associée au deuxième filtre optique métallique. Les métaux choisis pour les deux filtres sont indépendants des métaux utilisés pour les lignes d'interconnexions.

On peut ainsi choisir pour chaque filtre optique des dimensions et un métal adaptés au filtrage d'une longueur d'onde, chaque filtre étant formé à un niveau ayant une hauteur distincte des plans à partir desquels on forme des niveaux de métallisation.

Pour des zones photosensibles adjacentes, il est possible de former les deux filtres à un niveau bas du dispositif imageur intégré pour limiter les phénomènes de « cross-talk ».

On peut noter que c'est parce que les faces supérieures des régions diélectriques inférieures des deux filtres ne sont pas contenues dans un même plan qu'il est possible d'utiliser des métaux différents pour ces deux filtres.

La face supérieure de la première région diélectrique inférieure et la face supérieure de la deuxième région diélectrique inférieure peuvent être contenues dans une même zone diélectrique associée à un même niveau de métallisation.

Des filtres ayant des caractéristiques différentes peuvent ainsi être formés dans une épaisseur très fine, de préférence tous les deux près du substrat.

Le premier métal peut être du cuivre et le deuxième métal peut être de l'aluminium.

Les inventeurs ont observé que pour le filtrage de certaines couleurs, on obtient une meilleure transmission de la longueur d'onde à laisser passer, et une meilleur rejection des autres longueurs d'onde avec un métal bien choisi. En particulier, le cuivre est bien adapté pour laisser passer la couleur rouge ou le domaine proche infrarouge, et l'aluminium pour la couleur verte et la couleur bleue.

Comme indiqué ci-avant, c'est parce-que les faces supérieures des régions diélectriques inférieures sont contenues dans des plans distincts qu'il est possible d'utiliser des métaux différents.

On peut ainsi former au moins quatre filtres optiques métalliques pour former un motif de Bayer, les filtres optiques métalliques des pixels verts et du pixel bleu comprenant de l'aluminium, et le filtre optique du pixel rouge comprenant du cuivre. On obtient ainsi un meilleur dispositif imageur avec notamment une meilleure restitution des couleurs en utilisant un motif de Bayer.

D'autres types de matrice peuvent être réalisés selon le procédé défini ci avant en intégrant par exemple des pixels infrarouge ou UV.

Selon un autre aspect, il est proposé un dispositif imageur intégré à illumination face avant comprenant au moins une première zone photosensible dans un substrat, le dispositif comprenant :
- une première région diélectrique inférieure au-dessus de la face avant du substrat et de la première zone photosensible, la première région diélectrique inférieure ayant une face supérieure,
- au moins un premier filtre optique métallique comportant un motif métallique au dessus de la première zone photosensible, ledit filtre étant sur ladite face supérieure ou s'étendant dans la première région diélectrique inférieure depuis ladite face supérieure,
- une première région diélectrique supérieure au-dessus de la première région diélectrique inférieure et du premier filtre optique métallique formant avec au moins une partie de la première région diélectrique inférieure une première zone diélectrique associée à un niveau de métallisation du dispositif imageur intégré, ladite face supérieure de la première région diélectrique inférieure étant contenue dans ladite première zone diélectrique.

Le dispositif peut comprendre un deuxième filtre optique métallique au-dessus d'une deuxième zone photosensible disposée dans le substrat et distincte de la première zone photosensible.

Le premier filtre optique métallique peut comprendre un premier métal, le deuxième filtre optique métallique peut comprendre un deuxième métal différent du premier métal, la face supérieure de la première région diélectrique inférieure associée au premier filtre optique métallique étant contenue dans un plan distinct du plan contenant la face supérieure d'une deuxième région diélectrique inférieure associée au deuxième filtre optique métallique.

La face supérieure de la première région diélectrique inférieure et la face supérieure de la deuxième région diélectrique inférieure peuvent être contenues dans une même zone diélectrique associée à un même niveau de métallisation.

Le premier métal peut être du cuivre et le deuxième métal peut être de l'aluminium.

Le dispositif peut comprendre au moins quatre filtres optiques métalliques formant un motif de Bayer, les filtres optiques métalliques des pixels verts et du pixel bleu comprenant de l'aluminium, et le filtre optique rouge comprenant du cuivre. Le dispositif peut en outre comporter n'importe quel autre type de pixels d'autres couleurs, infrarouge ou UV, en fonction de l'application recherchée.

D'autres avantages et caractéristiques de l'invention apparaîtront à l'étude de la description détaillée de modes de mise en oeuvre et de réalisation, pris à titre d'exemples non limitatifs et illustrés par les dessins annexés sur lesquels :

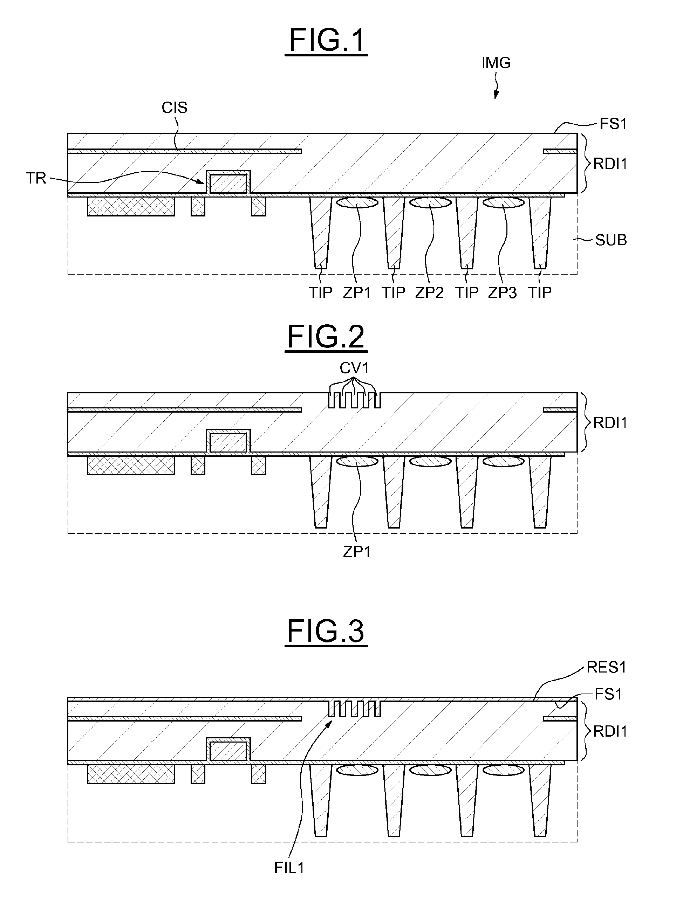

- les figures 1 à 7 illustrent de manière schématique différentes étapes d'un procédé de fabrication d'un dispositif imageur selon l'invention.

Sur la figure 1, on a représenté un dispositif imageur IMG ayant un substrat SUB dans lequel ont été formées des zones photosensibles ZP1, ZP2 et ZP3. Chaque zone photosensible ZP1, ZP2 ou ZP3 peut correspondre à une zone photosensible de pixel et peut par exemple être une photodiode, le dispositif imageur IMG pouvant être du type CMOS.

Pour délimiter les zones photosensibles ZP1, ZP2 et ZP3, des tranchées d'isolation profondes TIP (« DTI : Deep Trench Isolation » en langue anglaise) ont été formées dans le substrat.

Des transistors TR, ici de type MOS, on également été formés sur le substrat SUB.

Pour former un premier filtre optique métallique (du type plasmonique), on a formé une première région diélectrique inférieure RDI1 au-dessus de la face avant du substrat SUB et au moins de la première zone photosensible ZP1. La première région diélectrique inférieure a une face supérieure FS1 à partir de laquelle on va former le premier filtre optique métallique.

La formation de la première région diélectrique inférieure RDI1 comprend notamment une formation de couches isolantes CIS, par exemples utilisées pour la formation ultérieure de lignes de niveaux de métallisation. Ces couches isolantes CIS peuvent comprendre du nitrure de silicium ou du carbure-nitrure de silicium et sont formées par des étapes de dépôt.

Les couches isolantes CIS ne s'étendent pas au dessus des zones photosensibles ZP1, ZP1 et ZP3 pour obtenir de meilleures propriétés optiques.

On peut noter que la première région diélectrique inférieure RDI1 correspond ici à une portion d'une région de diélectrique pré-métal.

Pour former un filtre en cuivre, bien adapté pour filtrer la couleur rouge, on forme des cavités CV1 délimitant un motif périodique dans la première région diélectrique inférieure RDI1 au dessus de la zone photosensible ZP1 (figure 2). Les cavités CV1 ont des caractéristiques géométriques (dimensions latérale et profondeur) qui sont liées à la longueur d'onde à filtrer. L'homme du métier saura choisir ces caractéristiques géométriques en fonction de cette longueur d'onde à filtrer. A titre d'exemple, la profondeur des cavités CV1 (qui sera la hauteur du premier filtre), peut être comprise entre 25 et 200 nanomètres, ce qui est bien inférieur à l'épaisseur d'un niveau de métallisation (typiquement de quelques centaines de nanomètres à quelques micromètres).

Les cavités CV1 sont ensuite remplies par du cuivre, comme illustré sur la figure 3. On obtient ainsi un premier filtre FIL1 dans les cavités remplies, qui présente un motif métallique correspondant à celui délimité par les cavités CV1 décrites en se référant à la figure 2. Ce remplissage de cuivre peut être mis en oeuvre par un dépôt physique en phase vapeur (« PVD : Physical Vapor Déposition » en langue anglaise), et une première couche résiduelle de cuivre RES1 peut subsister après le remplissage sur la face supérieure FS1 de la première région diélectrique inférieure RDI1.

On peut noter que contrairement aux filtres selon l'art antérieur, et notamment aux filtres décrits dans le document US 2003/0103150, il n'est pas nécessaire de mettre en oeuvre un procédé analogue à celui utilisé pour former une ligne d'un niveau de métallisation qui comprend une formation de cavités, une formation de barrières comportant du tantale et du nitrure de tantale, et un remplissage par du cuivre. En effet, parce que le procédé de formation des filtres métalliques selon un aspect de l'invention n'est pas mis en oeuvre en même temps que la formation des niveaux de métallisation, il est avantageusement possible de ne pas utiliser de couches barrières qui peuvent nuire aux propriétés optiques des filtres.

Aucune électromigration du cuivre dans les régions diélectriques n'apparait ici, puisque les filtres optiques métalliques ne sont pas polarisés. En outre, une faible diffusion du cuivre due au budget thermique des étapes suivant la formation du filtre susceptible d'apparaitre n'impacterait pas les performances optiques de ce filtre.

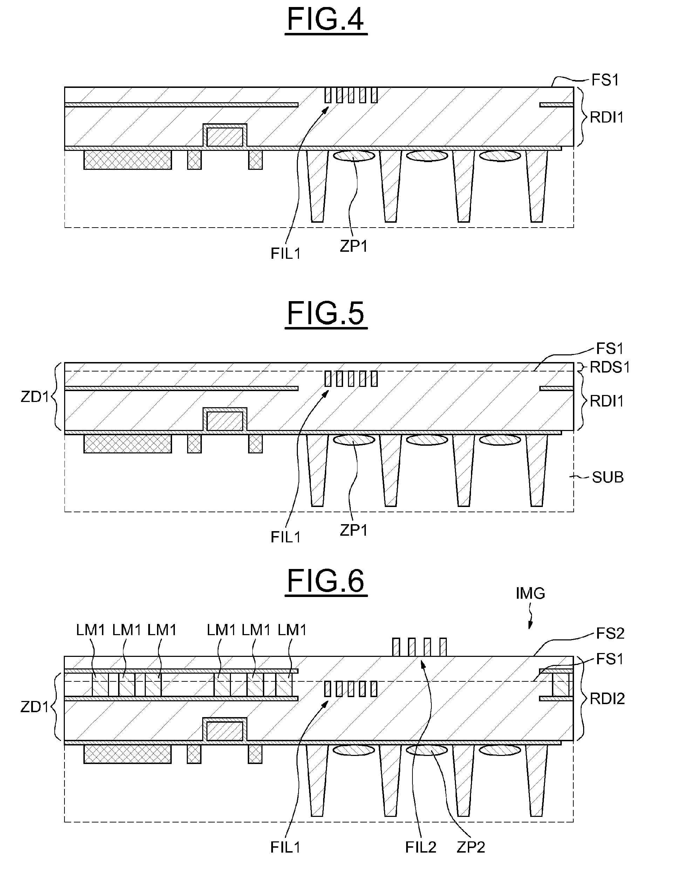

La première couche résiduelle RES1 de cuivre peut être retirée (figure 4). La face supérieure FS1 de la première région diélectrique inférieure est ainsi découverte et on laisse subsister un premier filtre FIL1 au dessus d'une première zone photosensible ZP1 et qui s'étend dans la première région diélectrique inférieure depuis sa face supérieure FS1.

Comme illustré sur la figure 5, on forme ensuite une première région diélectrique supérieure RDS1 au-dessus de la première région diélectrique inférieure RDI1 et du premier filtre optique métallique FIL1 pour former avec au moins une partie de la première région inférieure une première zone diélectrique ZD1 associée à un niveau de métallisation du dispositif imageur intégré formé ultérieurement, et la face supérieure FS1 de la première région diélectrique inférieure étant contenue dans ladite première zone diélectrique.

On obtient bien un dispositif imageur intégré IMG à illumination face avant comprenant au moins une première zone photosensible ZP1 dans un substrat SUB, le dispositif comprenant :
- une première région diélectrique inférieure RDI1 au-dessus de la face avant du substrat et de la première zone photosensible, la première région diélectrique inférieure ayant une face supérieure FS1,
- au moins un premier filtre optique métallique FIL1 comportant un motif métallique au dessus de la première zone photosensible, ledit filtre s'étendant dans la première région diélectrique inférieure,
- une première région diélectrique supérieure RDS1 au-dessus de la première région diélectrique inférieure et du premier filtre optique métallique formant avec au moins une partie de la première région diélectrique inférieure une première zone diélectrique ZD1 associée à un niveau de métallisation du dispositif imageur intégré, ladite face supérieure de la première région diélectrique inférieure étant contenue dans ladite première zone diélectrique.

Sur la figure 6, on a représenté le dispositif imageur IMG après une formation d'un niveau de métallisation comprenant des lignes LM1, ici le premier niveau de métallisation du dispositif imageur IMG. Le premier niveau de métallisation est associé à la première zone diélectrique ZD1 qui correspond à une région de diélectrique pré-métal.

On peut noter que la présence du premier filtre FIL1 ne perturbe nullement la formation des lignes métalliques LM1 qui sont formées depuis la face supérieure de la première zone diélectrique ZD1.

On a également formé une portion de diélectrique inter métallique pour obtenir une deuxième région diélectrique inférieure RDI2 ayant une face supérieure FS2 contenue dans un plan distinct de la face supérieure FS1 décrite ci-avant.

Sur la face supérieure FS2, on a formé un deuxième filtre métallique FIL2 au-dessus de la zone ZP2, ici en aluminium et donc bien adapté pour filtrer les couleurs bleues et vertes.

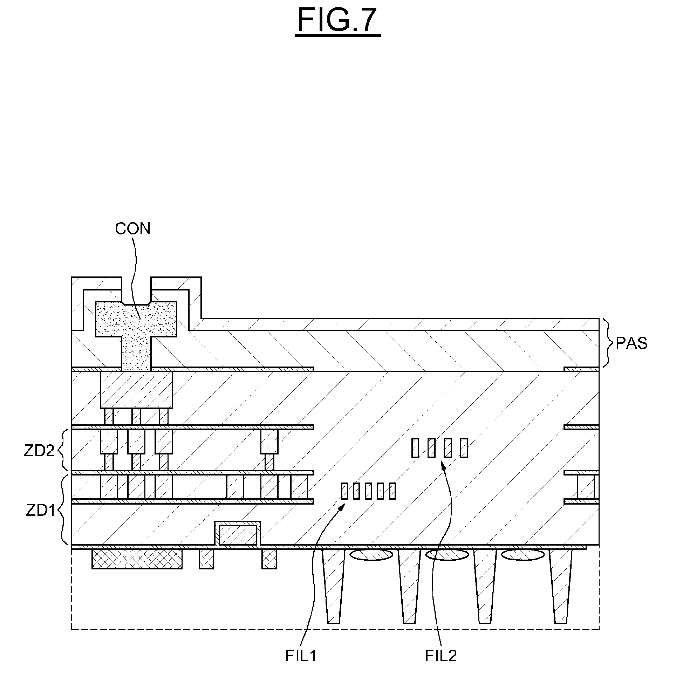

Sur la figure 7, on a représenté le dispositif imageur intégré IMG après un certain nombre d'étapes de fabrication.

Plus précisément, on a formé un deuxième niveau de métallisation associé à une deuxième zone diélectrique ZD2 du deuxième filtre métallique FIL2, un troisième niveau de métallisation et une connexion vers l'extérieur CON de type « pad » et des couches de passivation PAS.

On peut noter que la deuxième zone diélectrique ZD2 correspond ici à la région de diélectrique intermétallique associée au deuxième niveau de métallisation.

Par ailleurs, dans l'art antérieur, les filtres à pigments sont disposés au dessus du dispositif imageur intégré, ce qui entraine un mauvais fonctionnement lié au « cross-talk ». Ici, les filtres FIL1 et FIL2 sont disposés beaucoup plus bas. Tel est en particulier le cas du filtre FIL1 qui est disposé dans la zone diélectrique ZD1 qui correspond au diélectrique pré-métal, ce qui n'est pas possible avec les solutions de l'art antérieur.

Selon un aspect, l'invention n'est pas limitée aux filtres disposés dans des zones diélectriques distinctes. Il est possible de former des filtres à des hauteurs différentes dans une même zone diélectrique associée à un niveau de métallisation. Il est également possible de former un nombre plus grand de filtres différents au sein d'un même dispositif imageur intégré, par exemple pour former des motifs de Bayer.

Selon un autre aspect, on obtient plus facilement des filtres optiques métalliques, ou filtres plasmoniques, comprenant des motifs métalliques aux dimensions les mieux adaptées pour les longueurs d'onde à filtrer.

Enfin, selon encore un autre aspect, on obtient de meilleures propriétés optiques, parce que les filtres métalliques peuvent être formés directement dans les régions diélectriques sans couches supplémentaires.

## Revendications

1. Procédé de réalisation d'un dispositif imageur intégré à illumination face avant comprenant au moins une première zone photosensible (ZP1) dans un substrat(SUB), le procédé comprenant :
- une formation d'au moins une première région diélectrique inférieure (RDI1) au-dessus de la face avant du substrat et de la première zone photosensible, la première région diélectrique inférieure ayant une face supérieure (FS1),
- une formation d'au moins un premier filtre optique métallique (FIL1) comportant un motif métallique au-dessus de la première zone photosensible de pixel, ledit filtre étant sur ladite face supérieure ou s'étendant dans la première région diélectrique inférieure depuis ladite face supérieure,
- une formation d'une première région diélectrique supérieure (RDS1) au-dessus de la première région diélectrique inférieure et du premier filtre optique métallique pour former avec au moins une partie de la première région inférieure une première zone diélectrique (ZD1) associée à un niveau de métallisation du dispositif imageur intégré, ladite face supérieure de la première région diélectrique inférieure étant contenue dans ladite première zone diélectrique.

2. Procédé selon la revendication 1, dans lequel la face supérieure de la première région diélectrique inférieure est contenue dans un plan distinct de celui à partir duquel on forme le niveau de métallisation associé à la première zone diélectrique.

3. Procédé selon la revendication 1 ou 2, comprenant en outre une formation d'un deuxième filtre optique métallique (FIL2) au-dessus d'une deuxième zone photosensible (ZP2) distincte de la première zone photosensible.

4. Procédé selon la revendication 3, dans lequel on forme le premier filtre optique métallique (FIL1) avec un premier métal, on forme le deuxième filtre optique métallique (FIL2) avec un deuxième métal différent du premier métal, la face supérieure (FS1) de la première région diélectrique inférieure associée au premier filtre optique métallique étant contenue dans un plan distinct du plan contenant la face supérieure (FS2) d'une deuxième région diélectrique inférieure associée au deuxième filtre optique métallique.

5. Procédé selon la revendication 4, dans lequel la face supérieure de la première région diélectrique inférieure et la face supérieure de la deuxième région diélectrique inférieure sont contenues dans une même zone diélectrique associée à un même niveau de métallisation.

6. Procédé selon l'une quelconque des revendications 4 ou 5, dans lequel le premier métal est du cuivre et le deuxième métal est de l'aluminium.

7. Procédé selon la revendication 6, dans lequel on forme au moins quatre filtres optiques métalliques pour former un motif de Bayer, les filtres optiques métalliques des pixels verts et du pixel bleu comprenant de l'aluminium, et le filtre optique du pixel rouge comprenant du cuivre.

8. Dispositif imageur intégré à illumination face avant comprenant au moins une première zone photosensible (ZP1) dans un substrat (SUB), le dispositif comprenant :
- une première région diélectrique inférieure (RDI1) au-dessus de la face avant du substrat et de la première zone photosensible, la première région diélectrique inférieure ayant une face supérieure (FS1),
- au moins un premier filtre optique métallique (FIL1) comportant un motif métallique au dessus de la première zone photosensible, ledit filtre étant sur ladite face supérieure ou s'étendant dans la première région diélectrique inférieure depuis ladite face supérieure,
- une première région diélectrique supérieure (RDS1) au-dessus de la première région diélectrique inférieure et du premier filtre optique métallique formant avec au moins une partie de la première région diélectrique inférieure une première zone diélectrique (ZD1) associée à un niveau de métallisation du dispositif imageur intégré, ladite face supérieure de la première région diélectrique inférieure étant contenue dans ladite première zone diélectrique (ZD1).

9. Dispositif selon la revendication 8, dans lequel la face supérieure de la première région diélectrique inférieure est contenue dans un plan distinct de celui à partir duquel on forme le niveau de métallisation associé à la première zone diélectrique.

10. Dispositif selon la revendication 8 ou 9, comprenant un deuxième filtre optique métallique (FIL2) au-dessus d'une deuxième zone photosensible (ZP2) disposée dans le substrat et distincte de la première zone photosensible.

11. Dispositif selon la revendication 10, dans lequel le premier filtre optique métallique (FIL1) comprend un premier métal, le deuxième filtre optique métallique (FIL2) comprend un deuxième métal différent du premier métal, la face supérieure (FS1) de la première région diélectrique inférieure associée au premier filtre optique métallique étant contenue dans un plan distinct du plan contenant la face supérieure (FS2) d'une deuxième région diélectrique inférieure associée au deuxième filtre optique métallique.

12. Dispositif selon l'une quelconque des revendications 10 ou 11, dans lequel la face supérieure de la première région diélectrique inférieure et la face supérieure de la deuxième région diélectrique inférieure sont contenues dans une même zone diélectrique associée à un même niveau de métallisation.

13. Dispositif selon l'une quelconque des revendications 11 ou 12, dans lequel le premier métal est du cuivre et le deuxième métal est de l'aluminium.

14. Dispositif selon la revendication 13, comprenant au moins quatre filtres optiques métalliques formant un motif de Bayer, les filtres optiques métalliques des pixels verts et du pixel bleu comprenant de l'aluminium, et le filtre optique rouge comprenant du cuivre.
